# EUROPEAN PATENT SPECIFICATION

(11) **EP 1 993 135 B1**
(45) Date of publication and mention of the grant of the patent: **30.07.2014**
(21) Application number: 08251584.2
(22) Date of filing: 30.04.2008
(51) Int. Cl.: H01L 23/373

(54) **Heat conducter**
Wärmeleiter
Conducteur de chaleur

(30) Priority: 16.05.2007 JP 2007130968
(43) Date of publication of application: 19.11.2008
(73) Proprietor: Kabushiki Kaisha Toshiba, Minato-ku, Tokyo 105-8001 (JP)
(72) Inventor: Hasegawa, Tsuyoshi, Tokyo (JP)
(74) Representative: Granleese, Rhian Jane

(56) References cited:
- WO-A1-99/14805
- US-A- 3 678 995
- US-A1- 2007 289 730
- US-A1- 2008 067 673

## Description

### FIELD OF THE INVENTION

This invention relates to a heat conductor used for controlling heat dissipation of a heating element, such as various kinds of electronic components.

### DESCRIPTION OF THE BACKGROUND

Generally, a lamination of metal sheets and graphite sheets, which have better thermal conductivity than metals, are proposed for a heat conductor, since heating value is increasing due to higher electric power capacity of heating elements such as an electronic component. A heat conductor with an excellent thermal conductivity is desired.

Japanese patent laid-open publication No. 2001-144237 describes a graphite sheet lamination heat conductor having a laminated structure of graphite sheets and metal foils. Graphite has an excellent thermal or heat conductivity characteristic as compared with metal. In this graphite sheet lamination heat conductor, because of the graphite sheet, its weight can be reduced, and it becomes possible to radiate heat efficiently by raising the thermal conductivity in the sheet plane direction of the graphite sheet lamination heat conductor.

However, in the above-mentioned heat conductor, the thermal conductivity of the graphite sheet in the direction perpendicular to the sheet plane is inferior to that in the sheet plane direction, and the thermal conductivity in the direction perpendicular to the plane at a heat-receiving portion, for example, is inferior. For this reason, it has been difficult to cope with a high density mounting of electronic components and an acceleration of increasing output power, which are strongly demanded recently.

US3678995 relates to a heat conducting support comprising a substrate of good heat conductivity material and a diamond body embedded in the substrate.

### SUMMARY OF THE INVENTION

There is provided a heat conductor as recited in claim 1.

Additional objects and advantages of the invention will be set forth in part in the description which follows, and in part will be obvious from the description, or may be learned by practice of the invention. The objects and advantages of the invention will be realizes and attained by means of the elements and combinations particularly pointed out in the appended claims.

It is to be understood that both the foregoing general description and the following detailed description are exemplary and explanatory only and are not restrictive of the invention, as claimed.

### BRIEF DESCRIPTION OF THE BRAKINGS

The accompanying drawings, which are incorporated in and constitute a part of this specification, illustrate several embodiments of the invention and together with the description, serve to explain the principles of the invention.

Fig. 1 is a cross-sectional view of a main portion of a heat conductor according to the first embodiment.

Fig. 2 is an exploded perspective view of the heat conductor shown in Fig. 1.

Fig. 3 is an exploded perspective view illustrating a main portion of a heat conductor according to a second embodiment.

Fig. 4 is an exploded perspective view illustrating a main of a heat conductor according to a first comparative embodiment.

Fig. 5 is an exploded perspective view illustrating a main portion of a heat conductor according to a second comparative embodiment.

Fig. 6 is a cross-sectional view illustrating a main portion of a heat conductor according to a third embodiment.

Fig. 7 is an exploded perspective view illustrating the heat conductor shown in Fig. 6.

Fig. 8 is a cross-sectional view illustrating showing a main portion of a heat conductor according to a fourth embodiment.

Fig. 9 is an exploded perspective view illustrating the heat conductor shown in Fig. 8.

### DETAILED DESCRIPTION OF THE INVENTION

Now, embodiments will be explained in detail with reference to the drawings. According to the embodiments described herein, a heat conductor includes a plurality of first metal members, a plurality of second metal members, a plurality of graphite members. The heat conductor also includes a first heat conductive region and a second heat conductive region. The first heat conductive region is configured by a lamination of the first metal members and the graphite members. The second heat conductive region is configured by a lamination of the first metal members and the second metal members.

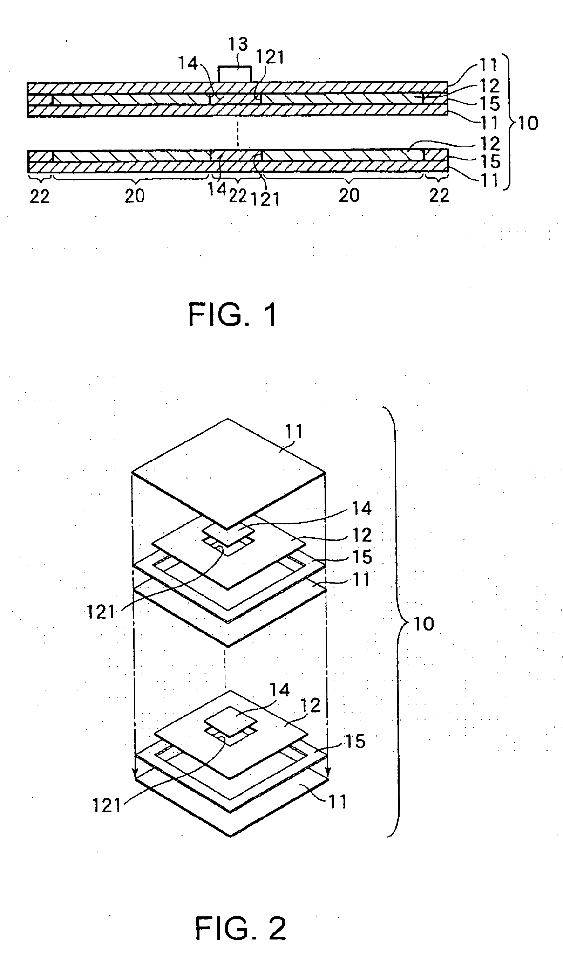

As shown in Fig. 1, heat conductor 10 according to the first embodiment has, for example, two or more first metal members 11 and two or more graphite members 12 in a laminated form so that each graphite member 12 is inserted between first metal members 11. In this embodiment, first metal member 11 is formed from a copper foil, for example, and graphite member 12 is formed by a lamination of two or more graphite sheets, for example.

As shown in Fig. 2, each graphite member 12 is bored with a square aperture 121 at the center, for example. Metal sheet 14, which forms a second metal member and is made of copper, for example, is provided in aperture 121 so that a surface of metal sheet 14 and a surface of graphite member 12 constitute a same, even surface.

Frame shaped metal sheet 15, which forms the second metal member and is made of copper foil, for example, is attached to a periphery of graphite member 12 so that a surface of frame shaped metal sheet 15 and the surface of graphite member 12 constitute a same surface. Metal sheet 14 and frame shaped metal sheet 15, which form the second metal members, are located between first metal members 11. Thereby, first metal members 11 are thermally connected via metal sheet 14 and frame shaped metal sheet 15, which are the second metal member.

First metal member 11, graphite member 12, metal sheet 14 and frame shaped metal sheet 15 are stacked and are subjected to pressurization and heating, for example, and thereby first metal member 11, metal sheet 14 and frame shaped metal sheet 15 are integrated by so called diffusion bonding, and first metal member 11 and graphite member 12 contact each other, and thus heat conductor 10 is manufactured. Here, first metal member 11 is copper and 0.1mm in thickness, graphite member 12 is 0.1mm in thickness. Both metal sheet 14 and frame shaped metal sheet 15 are copper and 0.1mm in thickness, respectively.

Heat conductor 10 includes first heat conductive region 20 and second heat conductive region 22. In first heat conductive region 20, first metal member 11 and graphite member 12 are laminated and thermally coupled. In second heat conductive region 22, first metal member 11 and the second metal member, which is formed by metal sheet 14 and frame shaped metal sheet 15, are laminated and thermally coupled. First heat conductive region 20 and second heat conductive region 22 are adjacently positioned.

Second heat conduction region 22 containing metal sheet 14 serves as a region which heating element 13, for example, electronic parts, is mounted on. When heat conductor 10 is used, heating element 13 is mounted on and thermally coupled to the topmost metal member 11.

According to above-mentioned structure, in heat conductor 10, if a heat from heating element 13 mounted on metal member 11 of second heat conductive region 22 transfers to metal member 11, the heat is diffused effectively to vertical direction to the plane through first metal member 11 and metal sheet 14 and frame shaped metal sheet 15, which form the second metal members. Metal member 11, metal sheet 14 and frame shaped metal sheet 15 have excellent thermal conductivities in vertical direction to the plane as compared with that of the graphite member 12.

Simultaneously the heat transferred to first metal member 11 transfers to graphite member 12, which has the excellent thermal conductivity in the plane direction, via first metal member 11 and metal sheet 14 and frame shaped metal sheet 15, which form the second metal members, and the heat diffuses effectively to the plane direction in graphite member 12. The heat transferred to graphite member 12, is diffused to lower graphite members 12 via first metal members 11 and is diffused to the plane direction in order and is conducted to whole heat conductor 10 uniformly.

According to this embodiment, heat diffusion in the plane direction is performed efficiently by graphite member 12 which is excellent in the heat conduction property in the plane direction as compared with that of first metal member 11. Heat diffusion in vertical direction to the plane is performed efficiently by first metal member 11, and metal sheet 14 and frame shaped metal sheet 15, which form the second metal member. First metal member 11, metal sheet 14 and frame shaped metal sheet 15 are excellent in the heat conduction property in the vertical or perpendicular direction to the plane direction as compared with than of the graphite sheet 12.
Thereby, the heat transferred to metal member 11 from heating element 13 is conducted to whole heat conductor 10 uniformly and quickly.
As a result, the heat conductor with the excellent thermally conductive ability, which uses the whole of the heat conductor uniformly, can be formed, and it becomes possible to realize a high efficient thermal control.

In the above-mentioned embodiment, since first heat conductive region 20 is surrounded by second heat conductive region 22, that is, because of a structure that an edge of graphite member 12 is not exposed by frame shaped metal sheet 15, mechanically weak graphite member 12 can be protected. In the above-mentioned embodiment, second heat conductive region 22 is divided into plural regions, for example two regions, by first heat conductive region 20, where one region corresponds to metal sheet 14 and the other region corresponds to frame shaped metal sheet 15. In this embodiment, a number of aperture 121 provided with graphite member 12 is not limited one, two or more is available and metal sheets 14 are arranged in the apertures 121 respectively.

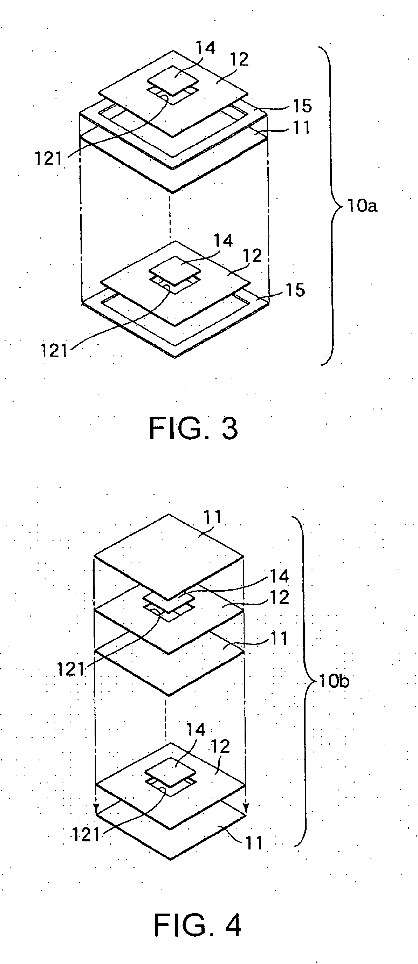

This invention is not limited to the above-mentioned embodiment, and other embodiments of the heat conductor are illustrated as heat conductors 10a, 10b, 1 0c, 10d, and 10e in Fig. 3, Fig. 4, Fig. 5, Fig. 6, Fig. 7, Fig. 8 and Fig. 9. The embodiments shown in Figs. 3-9 will be explained next. In Figs. 3-9, the same numerals denote the same portions illustrated in Fig. 1 and Fig. 2, and detailed explanations of those elements are omitted.

Fig. 3 shows a heat conductor according to the second embodiment. In heat conductor 10a, topmost metal member 11 and lowermost metal member 11 shown in Fig. 1 and Fig. 2 are not provided and graphite members 12, which are attached with frame shaped metal sheets 15 at periphery and metal sheets 14 in apertures 121, are provided at a topmost part and at a lowermost part. As a modification of this embodiment, heat conductor 10a may have first metal member 11 at the lowermost part or at the topmost part, and graphite member 12 may be exposed at the other part.

Fig. 4 shows a heat conductor according to the first comparative embodiment which does not form part of the invention. Heat conductor 10b does not have frame shaped metal sheet 15 attached to a periphery of graphite member12 shown in Figs. 1 and 2, and thereby a peripheral edge of graphite member 12 is exposed.

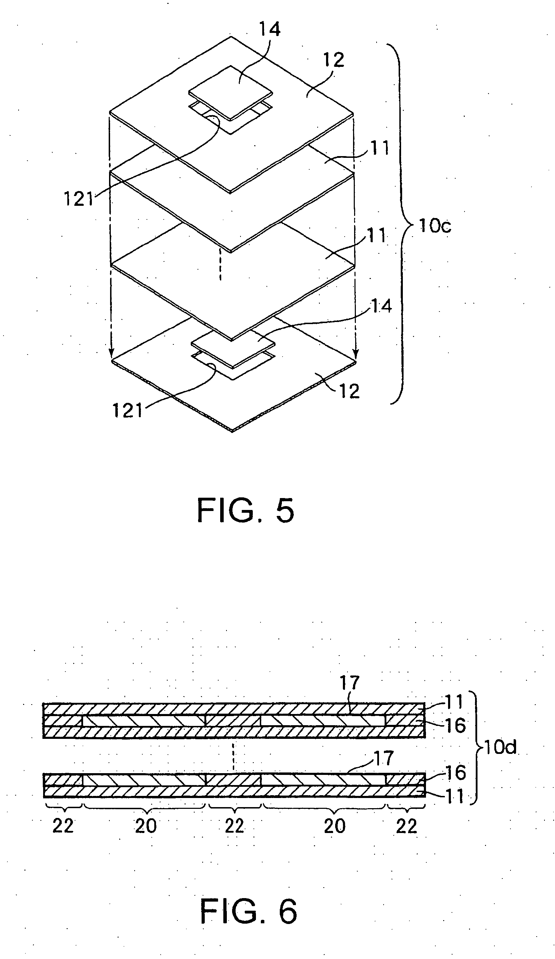

Fig. 5 shows a heat conductor according to the second comparative embodiment which does not form part of the invention. In heat conductor 10c, graphite sheets 12 is exposed directly at a topmost part and at a lowermost part without first metal members 11 arranged at the topmost part and at the lowermost part of heat conductor 10b shown in Fig. 4. As a modification of this embodiment, heat conductor 10c may have first metal member 11 at one of the lowermost part and the topmost part, and the graphite sheet 12 may be exposed at the other part.

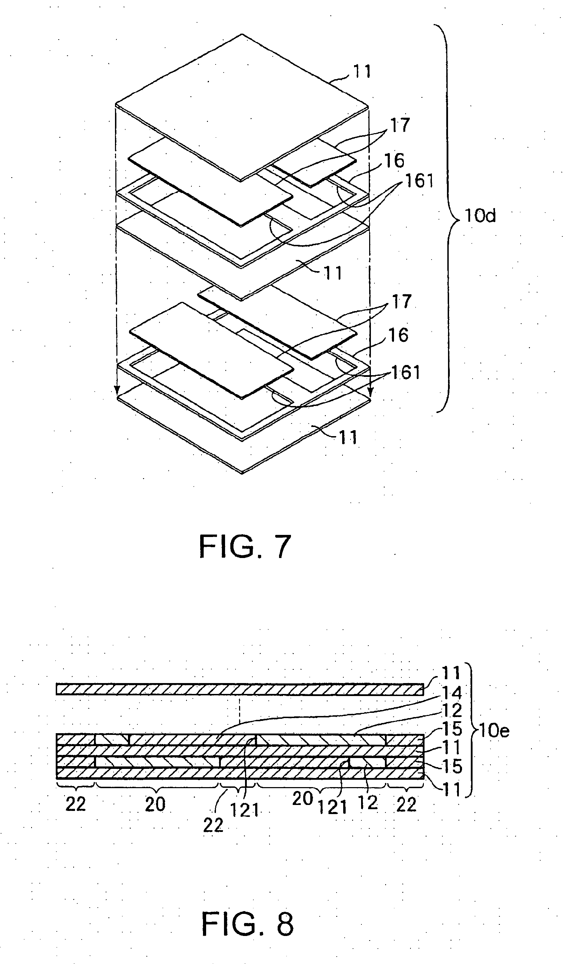

Figs. 6 and 7 show a heat conductor according to the third embodiment. In heat conductor 10d, frame shaped metal sheet 16, which is second metal member, has two apertures 161 separated each other and graphite members 17, which are made of graphite sheets, for example, are attached in aperture 161 respectively. Heat conductor 10d is formed by laminating a plurality of frame shaped metal sheets 16 with two graphite members 17 disposed separately each other and a plurality of first metal members 11 so that frame shaped metal member 17 is interposed between first metal members 11.

In other words, in heat conductor 10d, two graphite members 17 are separately arranged in two apertures 161 of frame shaped metal sheet 16. Thereby, first heat conductive region 20, which includes a lamination of first metal member 11 and graphite member 17, is divided into plural regions by second conductive region 22, which includes a lamination of first metal member 11 and the second metal member. In this embodiment, a number of aperture 161 provided with frame shaped metal sheet 16 is not limited two, three or more is available and graphite members 17 are arranged in the apertures 161 respectively. Also in this embodiment, graphite member 12 may be exposed without providing first metal member 11 at least one of at an upper surface and at a lower surface of heat conductor 10d.

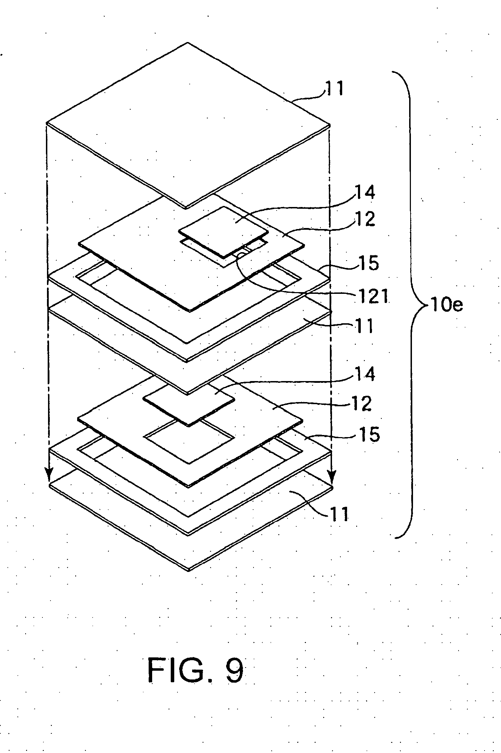

Figs. 8 and 9 show a heat conductor according to the fourth embodiment. In heat conductor 10e, a position of aperture 121 formed with graphite member 12 is shifted in order, for example, in a predetermined direction, and thereby a position of metal sheet 14, which is the second metal member and are received in aperture 121, is shifted between adjacent graphite sheets 12 via first metal member 11. Thus, apertures 121 are positioned in a stagger pattern. Thereby two metal sheets 14, which are the second metal member and are received in apertures 121 of adjacent two graphite members 12 via first metal member 11, are connected and arranged in stairs shape. Also in this embodiment, graphite member 12 may be exposed without providing first metal member 11 at least one of at a lowermost part and at a topmost part of heat conductor 10e.

In above-mentioned embodiments, a number of the laminated layer of the first metal member and the graphite member with the second metal member, which is the metal sheet and the frame shaped metal member, is not limited, if two or more. Moreover, the graphite member itself may be made of, for example, a lamination of a plurality of graphite sheets in layers, or graphite powder. Although the first metal member and the second metal member are formed of copper in above-mentioned embodiments, the first metal member and the second metal member may be formed of aluminum, copper alloy and aluminum alloy, and similar effect are obtained in those case.

## Claims

1. A heat conductor, comprising:
a first heat conductive region (20) configured by a lamination of a first metal member (11) and a graphite member (12), and
a second heat conductive region (22) configured by a lamination of the first metal member (11) and a second metal member (14, 15, 16),
wherein the first (20) and the second (22) heat conductive regions are adjacently positioned, and
wherein the second metal member (14, 15, 16) is formed by a metal sheet and a frame shaped metal sheet, and
wherein the metal sheet serves as a region on which a heating element (13) is mounted.

2. The heat conductor according to claim 1, wherein the second heat conductive region (22) is divided into plural regions by the first heat conducting region (20).

3. The heat conductor according to claim 1, wherein the first heat conductive region (20) is divided into plural regions by the second heat conductive region (22).

4. The heat conductor according to claim 1, wherein the first heat conductive region (20) is surrounded by the second heat conductive region (22).

5. The heat conductor according to any preceding claim, wherein the first metal member (11) is made of copper.

6. The heat conductor according to claim 5, wherein the second metal member (14, 15, 16) is made of copper.

7. The heat conductor according to claim 1, wherein the graphite member (12) in the first heat conductive region (20) and the second metal member (14, 15, 16) in the second heat conductive region (22) form an even surface.

8. The heat conductor according to claim 1, wherein the graphite member (12) has an aperture (121) and the second metal member (14) is arranged in the aperture (121) of the graphite member (12).

9. The heat conductor according to claim 1, wherein the second metal member (15, 16) has an aperture (161) and the graphite member (12, 17) is arranged in the aperture (161) of the second metal member (15, 16).

10. The heat conductor according to claim 9, wherein the second metal member (16) has two or more apertures (161) and the graphite members (17) are arranged in the apertures (161) of the second metal member (16).

11. The heat conductor according to claim 8, comprising a plurality of first metal members, a plurality of graphite members and a plurality of second metal members, so that each graphite member is inserted between first metal members.

12. The heat conductor according to claim 9, comprising a plurality of first metal members, a plurality of graphite members and a plurality of second metal members, so that each second metal member is inserted between first metal members.

13. The heat conductor according to claim 11, wherein the apertures (121) of the adjacent two graphite members (12) are positioned in a stagger pattern.

## Patentansprüche

1. Wärmeleiter, der aufweist:
einen ersten wärmeleitenden Bereich (20), der durch eine Schichtenbildung eines ersten Metallelementes (11) und eines Graphitelementes (12) gebildet wird; und
einen zweiten wärmeleitenden Bereich (22), der durch eine Schichtenbildung des ersten Metallelementes (11) und eines zweiten Metallelementes (14, 15, 16) gebildet wird,
wobei der erste (20) und der zweite wärmeleitende Bereich (22) benachbart positioniert sind, und
wobei das zweite Metallelement (14, 15, 16) durch ein Blech und ein rahmenförmiges Blech gebildet wird, und
wobei das Blech als ein Bereich dient, auf dem ein Heizelement (13) montiert wird.

2. Wärmeleiter nach Anspruch 1, bei dem der zweite wärmeleitende Bereich (22) in mehrere Bereiche durch den ersten wärmeleitenden Bereich (20) aufgeteilt wird.

3. Wärmeleiter nach Anspruch 1, bei dem der erste wärmeleitende Bereich (20) in mehrere Bereiche durch den zweiten wärmeleitenden Bereich (22) aufgeteilt wird.

4. Wärmeleiter nach Anspruch 1, bei dem der erste wärmeleitende Bereich (20) durch den zweiten wärmeleitenden Bereich (22) umgeben wird.

5. Wärmeleiter nach einem der vorhergehenden Ansprüche, bei dem das erste Metallelement (11) aus Kupfer besteht.

6. Wärmeleiter nach Anspruch 5, bei dem das zweite Metallelement (14, 15, 16) aus Kupfer besteht.

7. Wärmeleiter nach Anspruch 1, bei dem das Graphitelement (12) im ersten wärmeleitenden Bereich (20) und das zweite Metallelement (14, 15, 16) im zweiten wärmeleitenden Bereich (22) eine ebene Fläche bilden.

8. Wärmeleiter nach Anspruch 1, bei dem das Graphitelement (12) eine Öffnung (121) aufweist und das zweite Metallelement (14) in der Öffnung (121) des Graphitelementes (12) angeordnet wird.

9. Wärmeleiter nach Anspruch 1, bei dem das zweite Metallelement (15, 16) eine Öffnung (161) aufweist und das Graphitelement (12, 17) in der Öffnung (161) des zweiten Metallelementes (15, 16) angeordnet wird.

10. Wärmeleiter nach Anspruch 9, bei dem das zweite Metallelement (16) zwei oder mehr Öffnungen (161) aufweist und die Graphitelemente (17) in der Öffnung (161) des zweiten Metallelementes (16) angeordnet werden.

11. Wärmeleiter nach Anspruch 8, der eine Vielzahl von ersten Metallelementen, eine Vielzahl von Graphitelementen und eine Vielzahl von zweiten Metallelementen aufweist, so dass jedes Graphitelement zwischen den ersten Metallelementen eingesetzt wird.

12. Wärmeleiter nach Anspruch 9, der eine Vielzahl von ersten Metallelementen, eine Vielzahl von Graphitelementen und eine Vielzahl von zweiten Metallelementen aufweist, so dass jedes zweite Metallelement zwischen den ersten Metallelementen eingesetzt wird.

13. Wärmeleiter nach Anspruch 11, bei dem die Öffnungen (121) der benachbarten zwei Graphitelemente (12) in einem versetzten Anordnungsmuster positioniert sind.

## Revendications

1. Conducteur de chaleur, comprenant :
une première région conductrice de chaleur (20), configurée par une stratification d'un premier élément métallique (11) et d'un élément de graphite (12) ; et
une deuxième région conductrice de chaleur (22), configurée par une stratification du premier élément métallique (11) et d'un deuxième élément métallique (14, 15, 16) ;
dans lequel les première (20) et deuxième (22) régions conductrices de chaleur sont positionnées de manière adjacente ; et
dans lequel le deuxième élément métallique (14, 15, 16) est formé par une feuille métallique et une feuille métallique en forme de cadre ; et
dans lequel la feuille métallique sert de région sur laquelle un élément de chauffage (13) est monté.

2. Conducteur de chaleur selon la revendication 1, dans lequel la deuxième région conductrice de chaleur (22) est divisée en plusieurs régions par la première région conductrice de chaleur (20).

3. Conducteur de chaleur selon la revendication 1, dans lequel la première région conductrice de chaleur (20) est divisée en plusieurs régions par la deuxième région conductrice de chaleur (22).

4. Conducteur de chaleur selon la revendication 1, dans lequel la première région conductrice de chaleur (20) est entourée par la deuxième région conductrice de chaleur (22).

5. Conducteur de chaleur selon l'une quelconque des revendications précédentes, dans lequel le premier élément métallique (11) est composé de cuivre.

6. Conducteur de chaleur selon la revendication 5, dans lequel le deuxième élément métallique (14, 15, 16) est composé de cuivre.

7. Conducteur de chaleur selon la revendication 1, dans lequel l'élément de graphite (12) dans la première région conductrice de chaleur (20) et le deuxième élément métallique (14, 15, 16) dans la deuxième région conductrice de chaleur (22) forment une surface plane.

8. Conducteur de chaleur selon la revendication 1, dans lequel l'élément de graphite (12) comporte une ouverture (121), le deuxième élément métallique (14) étant agencé dans l'ouverture (121) de l'élément de graphite (12).

9. Conducteur de chaleur selon la revendication 1, dans lequel le deuxième élément métallique (15, 16) comporte une ouverture (161), l'élément de graphite (12, 17) étant agencé dans l'ouverture (161) du deuxième élément métallique (15, 16).

10. Conducteur de chaleur selon la revendication 9, dans lequel le deuxième élément métallique (16) comporte deux ou plusieurs ouvertures (161), les éléments de graphite (17) étant agencés dans les ouvertures (161) du deuxième élément métallique (16).

11. Conducteur de chaleur selon la revendication 8, comprenant plusieurs premiers éléments métalliques, plusieurs éléments de graphite et plusieurs deuxièmes éléments métalliques, de sorte que chaque élément de graphite est inséré entre des premiers éléments métalliques.

12. Conducteur de chaleur selon la revendication 9, comprenant plusieurs premiers éléments métalliques, plusieurs éléments de graphite et plusieurs deuxièmes éléments métalliques, de sorte que chaque deuxième élément métallique est inséré entre des premiers éléments métalliques.

13. Conducteur de chaleur selon la revendication 11, dans lequel les ouvertures (121) des deux éléments de graphite adjacents (12) sont positionnées dans un motif en quinconce.
